# EUROPEAN PATENT SPECIFICATION

(11) **EP 4 470 111 B1**
(45) Date of publication and mention of the grant of the patent: **04.03.2026**
(21) Application number: 23705868.0
(22) Date of filing: 18.01.2023
(51) Int. Cl.: H03K 17/16

(54) **OUTPUT CURRENT DETECTION IN HIGH-SIDE SWITCH**
AUSGANGSSTROMDETEKTION IN EINEM HIGH-SIDE-SCHALTER
DÉTECTION DE COURANT DE SORTIE DANS UN COMMUTATEUR CÔTÉ HAUT

(30) Priority: 26.01.2022 US 202263303322 P; 27.10.2022 US 202217974968
(43) Date of publication of application: 04.12.2024
(73) Proprietor: Texas Instruments Incorporated, Dallas, TX 75265-5474 (US)
(72) Inventor: RAHMAN, Md, Abidur, Dallas, TX 75243 (US); KIM, Eung, Jung, Dallas, TX 75243 (US); QU, Wenchao, Plano, TX 75074 (US)
(74) Representative: Zeller, Andreas
(86) International application number: PCT/US2023/060796
(87) International publication number: WO 2023/147234

(56) References cited:
- US-A1- 2014 049 238
- US-A1- 2014 253 089
- US-A1- 2018 123 578

## Description

### BACKGROUND

A high-side switch in an automotive or industrial application may couple to a power supply and provide power for downstream circuitry from the main power supply. The high-side switch may include diagnostic and protection circuitry. A cable or other connection may connect the high-side switch to the downstream circuitry. Wire-break detection detects a disconnection between the high-side switch and the downstream circuitry. US 2014/049238 A1 discloses methods and apparatuses for sensing current flowing in a power transistor of a switch mode converter. Further, US 2014/253089 A1 discloses apparatus and methods for current sensing in switching regulators. Moreover, US 2018/123578 A1 discloses current sensing and control for a transistor power switch.

### SUMMARY

The invention is defined by the features of the appended claims. In at least one example of the description, a system includes a first power stage including a first power field effect transistor (FET) and a first sense transistor coupled to the first power FET. The system also includes a second power stage including a second power FET and a second sense transistor coupled to the second power FET, where the second power stage is smaller than the first power stage. The system includes a first switch coupled to a gate and a drain of the first power FET and a second switch coupled to the first power stage and the second power stage. The system also includes a sense amplifier coupled to the second switch, where the first power stage, the second power stage, and the sense amplifier are coupled to a load terminal.

In at least one example of the description, a system includes a first power stage including a first power FET and a first sense transistor coupled to the first power FET, where the first power stage is configured to provide a first current to a load terminal. The system also includes a second power stage including a second power FET and a second sense transistor coupled to the second power FET, where the second power stage is smaller than the first power stage, and where the second power stage is configured to provide a second current to the load terminal. The system includes a first switch coupled to a gate and a drain of the first power FET, where the first switch is configured to connect the gate to the drain of the first power FET. The system also includes a second switch coupled to the first power stage and the second power stage, where the second switch is configured to connect the first power stage or the second power stage to a sense amplifier.

In at least one example of the description, a method includes providing a first current to a load with a first power stage in a first mode of operation, where the first power stage includes a first power FET and a first sense transistor. The method includes switching to a second mode of operation. Responsive to switching to the second mode of operation, the method includes providing a second current to the load with a second power stage, where the second power stage includes a second power FET and a second sense transistor. The method also includes connecting the first power FET in a diode connected configuration. The method includes coupling the second sense transistor to a sense amplifier.

In at least one example of the description, a system includes a first transistor configured to provide a first current to a load terminal in a first mode of operation. The system also includes a second transistor configured to provide a second current to the load terminal in a second mode of operation. The system includes a switch coupled to a gate and a drain of the first transistor and configured to place the first transistor in a diode-connected configuration during the second mode of operation. The system also includes a comparator having a comparator output, a first comparator input, and a second comparator input, where the first comparator input is coupled to a voltage supply terminal, the second comparator input is coupled to the load terminal, and the comparator is configured to provide a signal to exit the second mode of operation based on a comparison between a supply voltage and a voltage at the load terminal.

### BRIEF DESCRIPTION OF THE DRAWINGS

FIG. 1A is a circuit diagram of a high-side switch in various examples.
FIG. 1B is a circuit diagram of a high-side switch in various examples.
FIG. 2A is collection of graphs showing wire break mode and detection in various examples.
FIG. 2B is collection of graphs showing wire break mode and detection in various examples.
FIG. 3 is block diagram of a high-side switch in various examples.
FIG. 4 is block diagram of a system with a high-side switch in various examples.
FIG. 5 is a flow diagram of a method for low power mode output current detection in a high-side switch in various examples.
FIG. 6 is a circuit diagram of a low-power-mode channel driver in various examples.

### DETAILED DESCRIPTION OF EXAMPLE EMBODIMENTS

A high-side switch may include a main power field effect transistor (FET) that couples power from a power supply to a load, such as downstream circuitry. The high-side switch may include additional diagnostic and protection circuitry coupled to the high-side switch. The high-side switch may include a sense FET coupled to the power FET to sense the current provided to the load by the power FET. The sense current is useful for controlling the current output of the power FET. The sense current may also be useful for detecting whether a wire break has occurred between the power FET and the load. A wire break may be detected by the output current dropping below a wire break threshold.

In some cases, the high-side switch includes sense circuitry that detects the output current provided to the load, where the output current may range from several hundred milliamps to as high as 40 Amps. However, the sense circuitry may be unable to accurately sense the output current if the output current is in the range of 300 microamps to a few milliamps. This smaller range is useful for detecting whether a wire break has occurred between the high-side switch and the load.

In examples herein, additional circuitry is included in the high-side switch that allows the high-side switch to accurately sense both high load currents and much smaller currents for wire break detection. In a normal mode of operation, a sense FET coupled to the power FET provides a sense current to a sense amplifier, and the sense current is useful for controlling the output current of the power FET. Responsive to the output current falling below a wire break detection threshold, a second mode of operation called a wire break mode is enabled. In the wire break mode, a controller disables part of the circuitry in the high-side switch and enables additional circuitry in the high-side switch to accurately measure the lower output current range to determine whether a wire break has occurred. In the wire break mode, a gate of the power FET is connected to a drain of the power FET to create a diode-connected power FET. Also, a p-channel metal oxide semiconductor (PMOS) power stage with a PMOS sense FET is turned on and coupled to the load (or a load terminal) and to the sense amplifier. The transistors in the PMOS power stage are smaller than the power FET and are capable of accurately sensing smaller output currents. The PMOS power stage provides a sense current, based on the output current, to the sense amplifier. A comparator determines whether this sense current is below a wire break threshold. Responsive to the sense current falling below the wire break threshold, a wire break fault is triggered.

In examples herein, the PMOS power stage improves current sense accuracy for wire break detection in parallel with the sense circuitry of the power FET. The existing sense amplifier of the high-side switch is useful for the wire break mode, so no additional amplifier is added to the circuit, which saves area. Multiple thresholds may be enabled for entering/exiting the wire break mode and for detecting a wire break. Also, by connecting the power FET in a diode-connected configuration during the wire break mode, the output voltage drop may be limited during a sudden output load current increase, which may otherwise be unsupported by the smaller PMOS power stage.

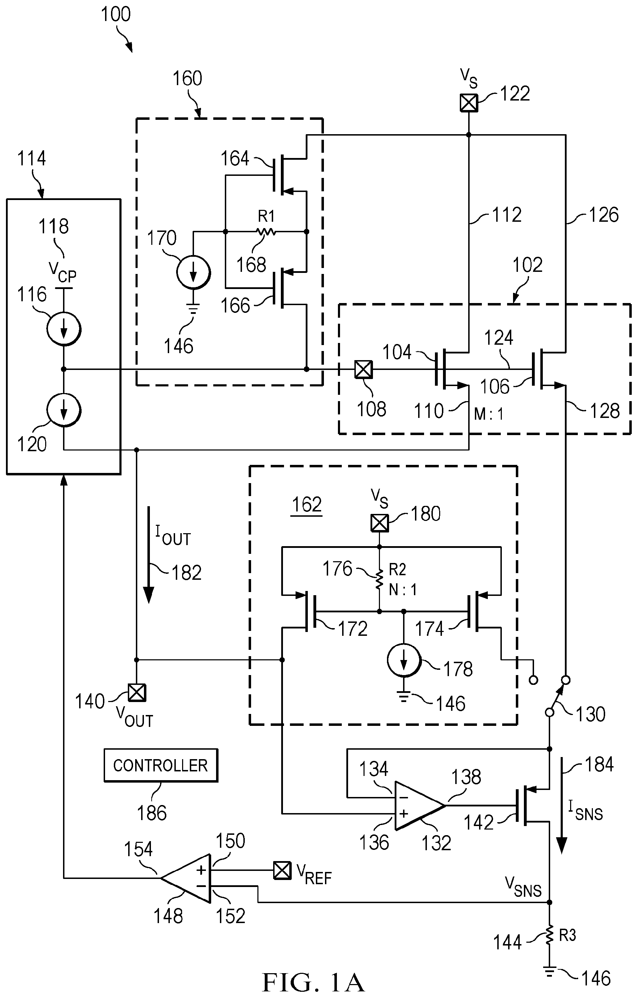

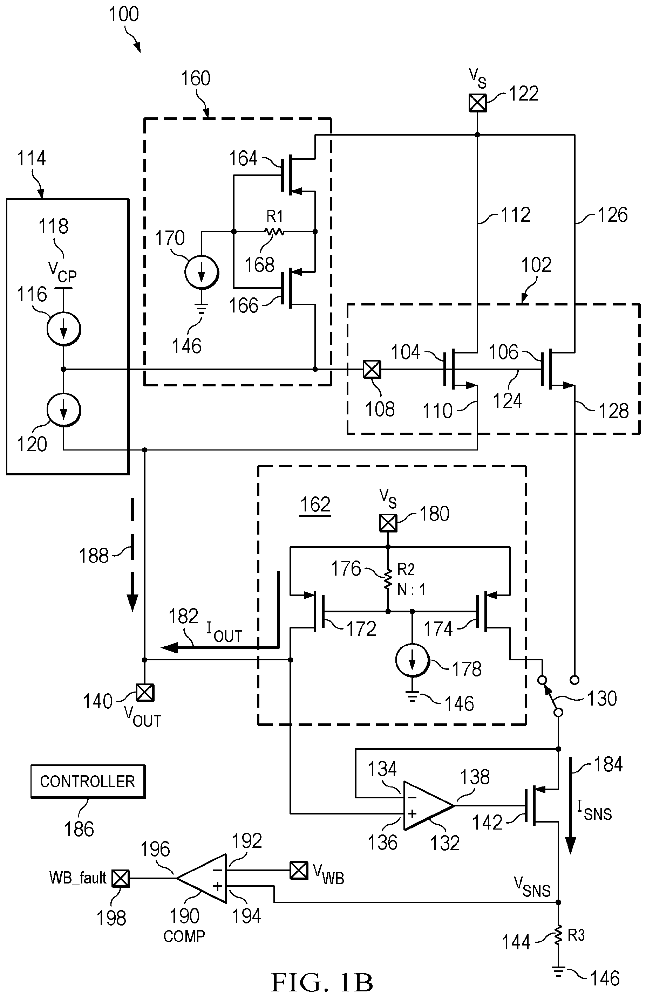

FIGS. 1A and 1B are circuit diagrams of a high-side switch with wire break detection in various examples herein. FIG. 1A shows a normal mode of operation for the high-side switch, while FIG. 1B shows a wire break mode of operation. Some circuitry may be enabled or disabled responsive to switching from the normal mode to the wire break mode and vice versa, as described herein.

FIG. 1A is a circuit diagram of a high-side switch 100 in the normal mode of operation in various examples herein. In the normal mode of operation, some wire break detection circuitry is disabled as described below. Also, in the normal mode of operation shown in FIG. 1A, a current sensing loop detects the output current with a sense current and controls the output current provided by the power FET. In this example, high-side switch 100 includes a main power stage 102. Main power stage 102 includes a power FET 104 and a sense FET 106 (e.g., a sense transistor). Power FET 104 and sense FET 106 are n-channel devices in this example, such as an n-channel metal oxide semiconductor (NMOS) transistor, but other types of transistors are useful in other examples. Power FET 104 and sense FET 106 have a size ratio of M:1 in one example. Power FET 104 includes a gate 108, a source 110, and a drain 112. The gate 108 is coupled to a charge pump 114. Charge pump 114 includes a pull-up current source 116 coupled to a charge pump voltage source V_{CP} 118. Charge pump 114 also includes a pull-down current source 120 coupled to gate 108 and source 110 of power FET 104. Drain 112 of power FET 104 is coupled to a supply voltage Vs at node 122, which may be a voltage supply terminal. In one example, Vs is approximately 13 V.

Sense FET 106 has a gate 124 coupled to gate 108 of power FET 104. Sense FET 106 has a drain 126 coupled to node 122 and a source 128 coupled to switch 130. Switch 130 couples sense FET 106 to sense amplifier 132. Sense amplifier has a first amplifier input 134, a second amplifier input 136, and an amplifier output 138. First amplifier input 134 is coupled to switch 130. Second amplifier input 136 is coupled to load 140 (or to a load terminal). Amplifier output 138 is coupled to transistor 142. Transistor 142 is coupled to resistor R3 144, which is coupled to ground 146. Resistor R3 and transistor 142 are also coupled to current sense amplifier 148. Current sense amplifier 148 has a first current sense amplifier input 150 coupled to a voltage reference V_{REF}. Current sense amplifier 148 has a second current sense amplifier input 152 coupled to resistor R3 144. Current sense amplifier 148 has a current sense amplifier output 154 coupled to charge pump 114.

High-side switch 100 also includes wire break detection circuitry that is disabled during the normal mode of operation. The wire break detection circuitry includes switch 160 and PMOS power stage 162 in this example. Switch 160 is configured to connect power FET 104 in a diode-connected configuration during the wire break mode. Switch 160 includes transistors 164 and 166, resistor R1 168, and current source 170. Transistors 164 and 166 may be PMOS transistors in one example. Switch 160 is coupled between gate 108 of power FET 104 and drain 112 of power FET 104. As described below, switch 160 connects power FET 104 in a diode-connected configuration during a wire break detection mode.

PMOS power stage 162 includes a PMOS power FET 172, a PMOS sense FET 174, resistor R2 176, and current source 178. PMOS power FET 172 and PMOS sense FET 174 have a size ratio of N:1 in one example. PMOS power FET 172 is coupled to a supply voltage Vs at node 180 and to load 140 responsive to PMOS power stage 162 being enabled. PMOS power stage 162 is coupled to sense amplifier 132 via switch 130 during the wire break detection mode, which is described below with respect to FIG. 1B. In this example, PMOS power stage 162 includes PMOS transistors, but this power stage may have other types of transistors in other examples.

FIG. 1A also includes an output current I_{OUT} 182 and a sense current I_{SNS} 184. FIG. 1A also includes a controller 186. Controller 186 controls some of the operations of high-side switch 100. For example, controller 186 is a digital controller that controls switches that allow high-side switch 100 to switch from normal operation mode to wire break detection mode, and vice versa. During normal operation mode, switch 130 connects sense FET 106 to sense amplifier 132. During wire break detection mode, controller 186 switches switch 130 to connect PMOS power stage 162 to sense amplifier 132. During wire break detection mode, controller 186 also disables charge pump 114 and connects switch 160 to power FET 104. The operations of wire break detection mode are described below with respect to FIG. 1B.

Referring again to FIG. 1A, in the normal operation mode switch 160 and PMOS power stage 162 are disabled. Power FET 104 provides an output current I_{OUT} 182 to drive load 140, and produce an output voltage V_{OUT} at load 140. Sense FET 106 senses the current provided by power FET 104 with an M:1 ratio, and mirrors the output current I_{OUT} 182 to provide the sense current I_{SNS} 184. Sense current I_{SNS} 184 travels through resistor R3 144, which creates a voltage V_{SNS} that is then provided to second current sense amplifier input 152. Current sense amplifier 148 and transistor 142 provide a current loop that receives sense current I_{SNS} 184. The output of current sense amplifier 148 at current sense amplifier output 154 controls the pull-up current source 116 and pull-down current source 120 in charge pump 114. Charge pump 114 in turn controls the amount of output current I_{OUT} 182 provided by power FET 104 to load 140. Therefore, the sense FET 106 provides the sense current I_{SNS} 184 to the current loop to control the operation of power FET 104 during the normal operation mode, as shown in FIG. 1A.

The normal operation mode may accurately sense current from several hundred milliamps to as high as 40 Amps, which is a 40X to 100X or more range of current detection. However, the sense circuitry that is enabled during the normal operation mode may be unable to accurately sense the output current if the output current is in the range of 300 microamps to a few milliamps, which may be the current range during a wire break condition. Detecting current from 300 microamps all the way to 40 Amps is a range of more than 100,000X, which is difficult to detect with a single current sensing loop.

In examples herein, for wire break detection, a separate current sensing loop is useful for detecting the smaller range of output current. The separate current sensing loop includes activating switch 160 and activating PMOS power stage 162 via switch 130 during a wire break detection mode. The wire break detection mode is described below with respect to FIG. 1B.

FIG. 1B is a circuit diagram of a high-side switch 100 in the wire break detection mode in various examples herein. The components shown in FIG. 1B are similar to the components shown in FIG. 1A, and like numerals denote like components. In the wire break detection mode, charge pump 114 is disabled, and sense FET 106 is disconnected from sense amplifier 132 by switch 130. Also, in wire break detection mode, switch 160 is activated, which places power FET 104 in a diode-connected configuration. PMOS power stage 162 is activated in wire break detection mode. In this mode, PMOS power stage 162 therefore provides the output current I_{OUT} 182 to load 140 and provides the sense current I_{SNS} 184 to sense amplifier 132. In FIG. 1B, power FET 104 may also provide an auxiliary current 188 to load 140 in some circumstances, as described below.

In operation, during the wire break detection mode, power FET 104 is configured into a diode connected configuration via switch 160. Responsive to entering wire break detection mode, controller 186 enables switch 160, and switch 160 couples gate 108 to drain 112 of power FET 104. Charge pump 114 is disconnected from power FET 104 and/or disabled. Responsive to entering wire break detection mode, sense FET 106 is disabled by switching switch 130. Responsive to entering wire break detection mode, PMOS power stage 162 is enabled and switch 130 connects PMOS power stage 162 to sense amplifier 132. Enabling PMOS power stage 162 couples PMOS power FET 172 to load 140 and to second amplifier input 136. Responsive to entering wire break detection mode, current sense amplifier output 154 is disconnected from charge pump 114. The coupling, decoupling, connecting, and disconnecting actions responsive to wire break detection mode may be controlled by controller 186 in some examples. Any type of circuitry is useful for connecting and disconnecting various circuit components responsive to switching operating modes as described herein, such as switches, transistors, etc.

Switch 160, after enabled, reconfigures power FET 104 as a diode connected FET. Connecting power FET 104 in a diode configuration allows power FET 104 to provide current to load 140 responsive to a large load current increase. In some examples, PMOS power stage 162 is smaller than main power stage 102. If a large load current increase occurs, the voltage V_{OUT} at load 140 may not be able to be maintained by PMOS power stage 162 alone. As one example, the impedance across PMOS power FET 172 may be 25 to 50 Ohms, while the impedance across power FET 104 may be 10-100 milliohms. For a 100 milliamp load current, PMOS power FET 172 may create a 2.5 to 5 V voltage drop at load 140. However, it is useful to keep the voltage V_{OUT} at load 140 near the supply voltage Vs of 13 V during operation in some examples. The voltage at V_{OUT} may be maintained with the diode configured power FET 104.

In this example, the power FET 104 is a large FET and is configured as a diode. If V_{OUT} drops more than the threshold voltage V_{Threshold} of the diode configured power FET 104 (about 1 V in one example), power FET 104 will turn on. Power FET 104 turns on because the voltage at gate 108 is Vs (e.g., about 13 V), and the voltage at source 110 has dropped by about 1 V or more in this example, which is the threshold voltage for turning on power FET 104. For example, if V_{S} - V_{OUT} > V_{Threshold}, then power FET 104 turns on. Power FET 104 provides additional current to load 140 if it is turned on, above the current that PMOS power stage 162 can provide to the load. The additional current provided by power FET 104 is shown as auxiliary current 188 in FIG. 1B. The power FET 104 in the diode configuration therefore limits the voltage drop at V_{OUT} during sudden load current changes in this example by providing additional auxiliary current 188. If V_{OUT} remains near Vs, then the gate-to-source voltage of power FET 104 remains below V_{Threshold}, and power FET 104 remains off in the wire break detection mode.

In the wire break detection mode, sense FET 106 is disconnected via switch 130. Therefore, PMOS power stage 162 provides current sensing via PMOS sense FET 174. The ratio of PMOS power FET 172 and PMOS sense FET 174 is N:1, which may be on the order of 10:1 in one example. Because PMOS power FET 172 and PMOS sense FET 174 are smaller than power FET 104, they can sense currents several magnitudes smaller than the normal current sensing loop in FIG. 1A. In one example, wire break detection requires current sensing from about 300 microamps to a few milliamps. The normal current sensing loop may not be this sensitive, but the PMOS power stage 162 can sense currents this small.

In the wire break detection mode, PMOS sense FET 174 mirrors the output current I_{OUT} 182 at a ratio of N:1 and provides sense current I_{SNS} 184. Sense current I_{SNS} 184 passes through resistor R3 144, and produces a voltage V_{SNS}. The voltage V_{SNS} is provided to a comparator 190. Comparator 190 includes a first comparator input 192, a second comparator input 194, and a comparator output 196. Comparator output 196 is coupled to a wire break fault node WB_fault 198. The V_{SNS} voltage is provided to second comparator input 194. A wire break reference voltage V_{WB} is provided to first comparator input 192. If the V_{SNS} voltage is less than the V_{WB} voltage, a wire break fault is reported at WB_fault 198. Therefore, as shown in FIG. 1B, wire break faults can be determined in the wire break detection mode during low output current situations, while still maintaining output voltage V_{OUT} responsive to changes in the output current.

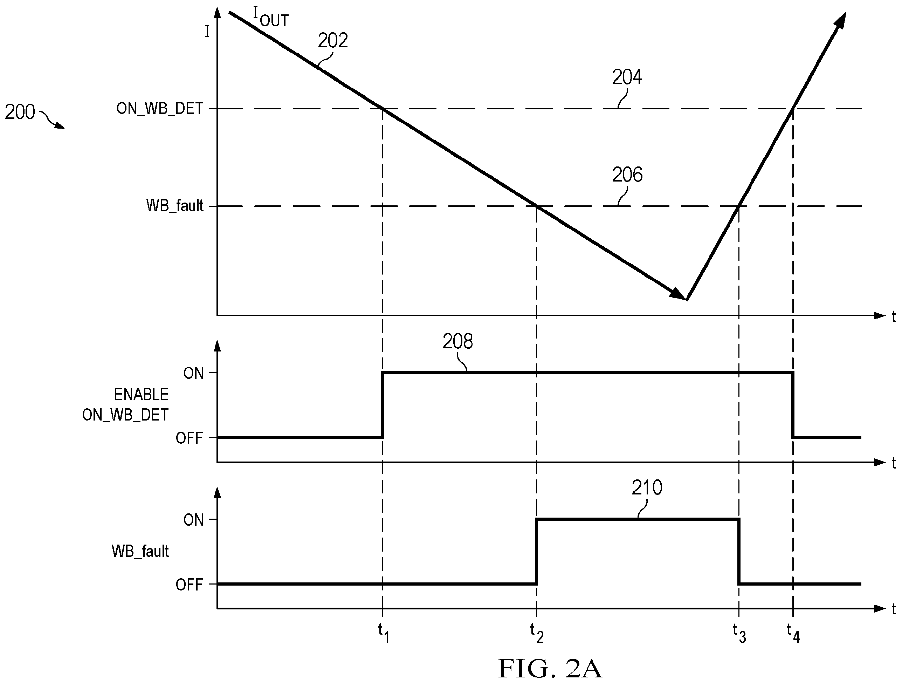

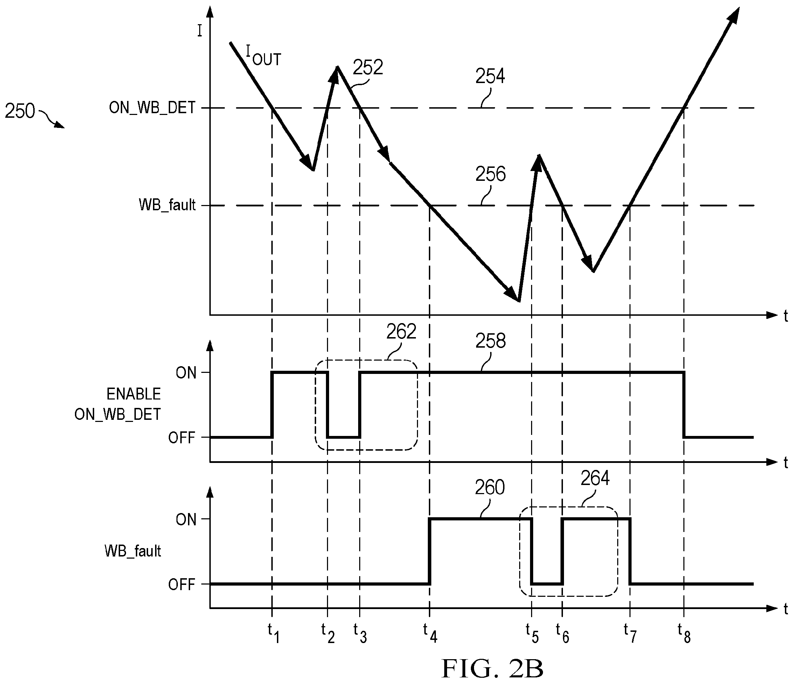

FIGS. 2A and 2B are collection of graphs showing wire break mode and detection in various examples herein. In FIG. 2A, graph 200 shows one example of output current versus time, and includes the status of a wire break detection mode and of a wire break fault. In FIG. 2B, graph 250 shows another example of output current versus time, where the output current is noisy and may cause glitching issues.

Referring again to FIG. 2A, graph 200 shows I_{OUT} as waveform 202. Graph 200 shows two thresholds for I_{OUT}: on wire break detection (ON_WB_DET) threshold 204 and wire break fault (WB_fault) threshold 206. If waveform 202 falls below ON_WB_DET 204, wire break detection mode turns on. Waveform 208 shows the status of wire break detection mode. If waveform 208 is low, wire break detection mode is off (e.g., high-side switch 100 is in normal operation mode). If waveform 208 is high, wire break detection mode is on. As shown in graph 200, waveform 202 (I_{OUT}) falls below ON_WB_DET 204 at time t₁. Responsive to waveform 202 falling below ON_WB_DET 204, waveform 208 goes from low to high. Therefore, at time t₁, high-side switch 100 enters wire break detection mode. In this example, high-side switch 100 remains in wire break detection mode until waveform 202 rises above ON_WB_DET 204. Waveform 202 rises above ON_WB_DET 204 at time t₄. Therefore, at time t₄, waveform 208 goes from high to low, and high-side switch 100 exits wire break detection mode.

As described above, high-side switch 100 enters and exits wire break detection mode based on the value of I_{OUT}. FIG. 1B shows the circuitry that is enabled and disabled during wire break detection mode. Controller 186 or other digital circuity may enable and disable certain circuit components during wire break detection mode. Also, controller 186 may monitor I_{OUT} to determine whether to enter wire break detection mode, such as time t₁ in graph 200.

If high-side switch 100 is in wire break detection mode, a wire break fault is not detected until I_{OUT} falls below the wire break fault threshold. The threshold for wire break fault 206 is shown in graph 200. The threshold for wire break fault threshold 206 is below the threshold for on wire break detection (ON_WB_DET) 204. Therefore, high-side switch 100 enters wire break detection mode if I_{OUT} falls below the threshold for wire break detection (ON_WB_DET) 204. While in wire break detection mode, a wire break fault is detected if I_{OUT} falls below wire break fault threshold 206. As shown in graph 200, I_{OUT} falls below wire break fault threshold 206 at time t₂. Therefore, at time t₂, a wire break is detected. Waveform 210 shows the wire break fault detection. At time t₂, wire break fault detection goes from low to high, and a wire break fault is indicated. The wire break fault indication continues until waveform 202 goes above wire break fault threshold 206. At time t₃, I_{OUT} goes above wire break fault threshold 206. Therefore, at time t₃, the wire break fault indicator goes from high to low.

FIG. 2A shows that a high-side switch 100 may enter a wire break detection mode based on a value of I_{OUT} falling below a first threshold. If the value of I_{OUT} falls below a second threshold, a wire break is indicated. The second threshold is below the first threshold. In one example, the first threshold may be approximately 4 mA. The second threshold may be 300 microamps to 2 mA in one example. The first threshold allows high-side switch 100 to operate in normal mode as long as I_{OUT} remains above the first threshold. If I_{OUT} falls below the first threshold, high-side switch 100 enters wire break detection mode and monitors I_{OUT} for a wire break at the second threshold.

FIG. 2B shows a graph 250 of output current versus time, where the output current is noisy and may cause glitching issues. Graph 250 shows I_{OUT} as waveform 252. Graph 250 shows two thresholds for I_{OUT}: on wire break detection (ON_WB_DET) threshold 254 and wire break fault (WB_fault) threshold 256. These two thresholds operate as described above with respect to FIG. 2A.

Graph 250 also shows waveform 258, which is the status of wire break detection mode. Waveform 260 is the status of the wire break fault WB_fault. Waveform 252 shows that at time t₁, high-side switch 100 enters wire break detection mode (e.g., waveform 258 goes high), because I_{OUT} falls below (ON_WB _DET) threshold 254. At time t₂, high-side switch 100 exits wire break detection mode (e.g., waveform 258 goes low). At time t₃, high-side switch 100 again enters wire break detection mode (e.g., waveform 258 goes high).

Because high-side switch 100 jumps in and out of wire break detection mode in this manner, waveform 258 is glitchy in area 262 of graph 250, shown as waveform 258 jumping between on and off states. Similarly, at time t₄, high-side switch 100 detects a wire break fault because waveform 252 (e.g., I_{OUT}) falls below threshold 256. Waveform 260 goes high at time t₄ to indicate a wire break. At time t₅, waveform 252 rises above threshold 256, and the wire break fault is released (e.g., waveform 260 goes low). At time t₆, high-side switch 100 again detects a wire break fault because waveform 252 falls below threshold 256. Then, at time t₇, waveform 252 rises above threshold 256, and the wire break fault is released (e.g., waveform 260 goes low) again. Waveform 260 is therefore also glitchy in area 264 because waveform 252 crosses threshold 256 repeatedly in a short period of time.

Deglitching may be performed to remove the glitches at areas 262 and 264. Any suitable deglitching processes are useful. For example, hysteresis may be added to the system to prevent high-side switch 100 from jumping in and out of wire break detection mode quickly, and to prevent wire break faults from turning on and off as shown in graph 250. In another example, digital control circuitry could be implemented that performs deglitching, such as a digital state machine.

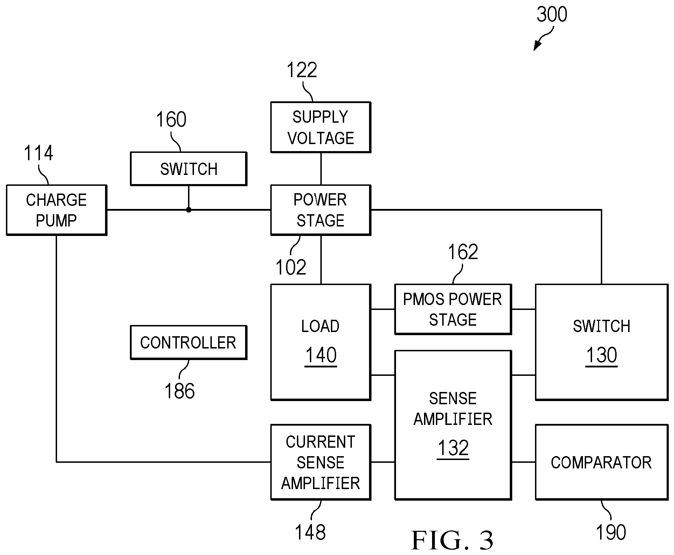

FIG. 3 is a block diagram of a high-side switch 300 in various examples herein. The components in high-side switch 300 are described above with respect to FIGS. 1A and 1B, and like numerals denote like components. High-side switch 300 shows the major components of a high-side switch, including a load 140. The components shown in high-side switch 300 may be implemented with any suitable digital or analog circuitry. FIGS. 1A and 1B show example circuity for these components, but other circuitry is useful in other examples. For example, switch 160 is a PMOS switch in FIGS. 1A and 1B, but any circuitry constituting a switch is useful in other examples. As another example, main power stage 102 includes an NMOS power FET in FIGS. 1A and 1B, but other circuitry is useful for creating main power stage 102 in other examples. Controller 186 may be any type of digital controller, digital circuitry, microcontroller, processor, or other suitable component.

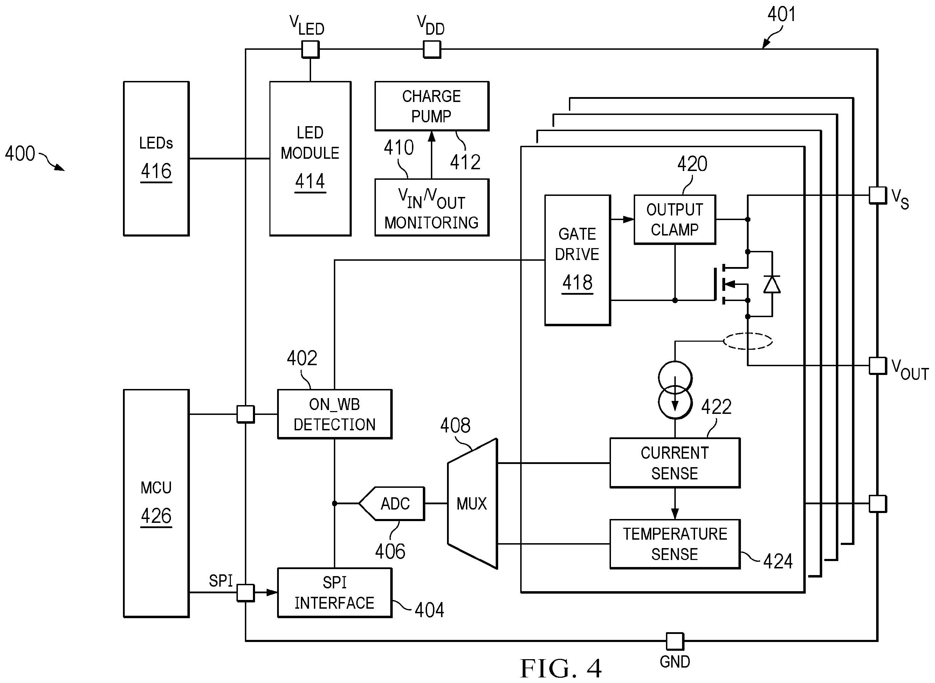

FIG. 4 is a block diagram of a system 400 with a high-side switch in various examples herein. System 400 includes an integrated circuit ("chip") 401. System 400 is useful for automotive or industrial application in some examples. System 400 is one example system that may include wire break detection, but wire break circuitry as described herein may be included in other systems in other examples. In this example, chip 401 includes wire break detection 402, serial peripheral interface (SPI) 404, analog to digital converter 406, and multiplexer 408. Chip 401 also includes input supply and output voltage monitoring 410, charge pump 412, and light emitting diode (LED) module 414. Led module 414 may be coupled to LEDs 416, which may be located outside chip 401. Chip 401 also includes gate drive 418, output clamp 420, current sense 422, and temperature sense 424. System 400 includes a microcontroller (MCU) 426 in this example.

In one example, wire break detection 402 includes some of the circuitry described above with respect to FIGS 1A and 1B. If wire break detection 402 detects a wire break, a fault signal is sent to MCU 426 via SPI 404. Voltage supply Vs may be 24 V in one example, and other voltages may be derived from the 24 V supply.

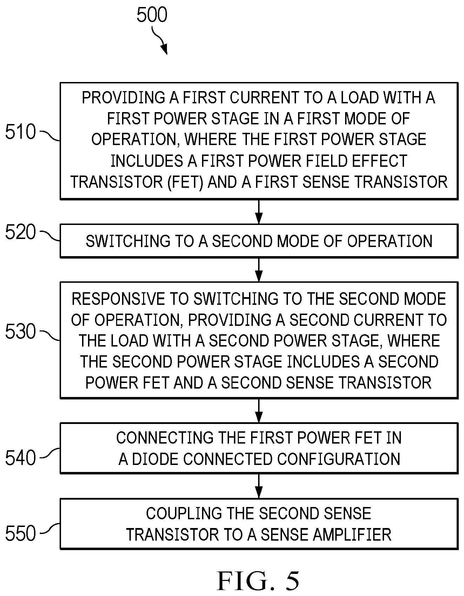

FIG. 5 is a flow diagram of a method 500 for low power mode output current detection in a high-side switch in various examples herein. The steps of method 500 may be performed in any suitable order. The hardware components described above with respect to FIGS. 1A, 1B, 3 or 4 may perform method 500 in some examples.

Method 500 begins at 510, where a first power stage, such as main power stage 102, provides a first current to a load (or to a load terminal) in a first mode of operation, where the first power stage includes a first power FET (such as power FET 104) and a first sense transistor (such as sense FET 106).

Method 500 continues at 520, where the method switches to a second mode of operation. In some examples, the method 500 switches to a second mode of operation responsive to an output current I_{OUT} 182 falling below a first threshold. Falling below the first threshold may indicate that the output current I_{OUT} 182 is near a wire break detection threshold, so the system switches to the wire break detection mode.

Method 500 continues at 530, where, responsive to switching to the second mode of operation, a second power stage (such as PMOS power stage 162) provides a second current to the load (or to the load terminal). The second power stage includes a second power FET (such as PMOS power FET 172) and a second sense transistor (such as PMOS sense FET 174). In other examples, transistors other than PMOS transistors are useful in the second power stage.

Method 500 continues at 540, where, responsive to switching to the second mode of operation, the first power FET (e.g., power FET 104) is connected in a diode configuration. In one example, switch 160 is activated to connect power FET 104 in the diode configuration. In other examples, a different type of switch or connection is useful.

Method 500 continues at 550, where, responsive to switching to the second mode operation, the second sense transistor is coupled to a sense amplifier. In one example, switch 130 switches to couple the second sense transistor (e.g., PMOS sense FET 174) to the sense amplifier 132. In the second mode of operation, PMOS sense FET 174 provides a sense current for determining wire break detection.

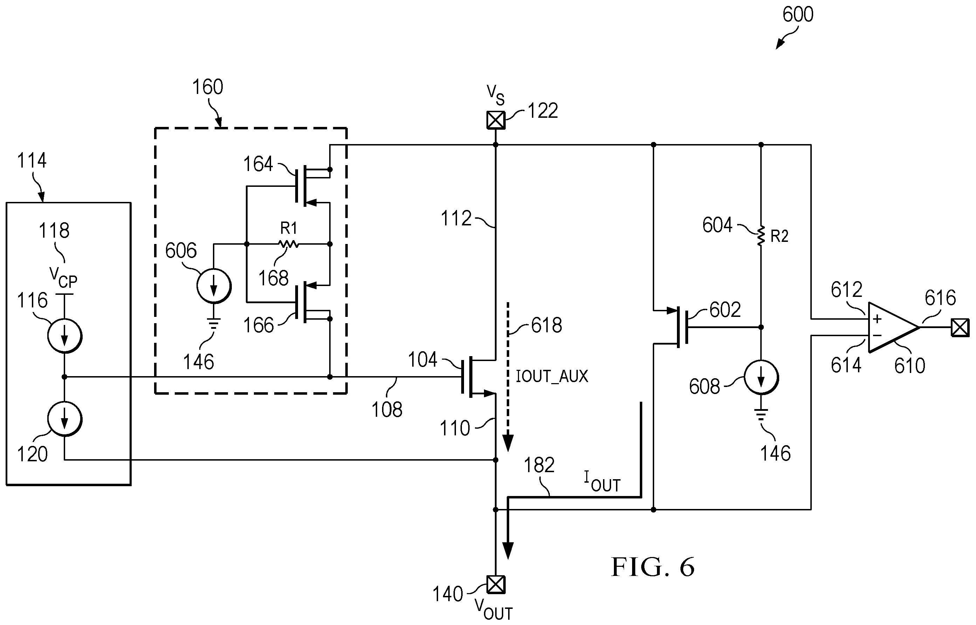

FIG. 6 is a circuit diagram of a low-power-mode (LPM) channel driver 600 in various examples herein. Some components shown in FIG. 6 are similar to the components shown in FIGS. 1A and 1B, and like numerals denote like components. Channel driver 600 also includes a transistor 602, resistor R2 604, first bias current source 606, second bias current source 608, and comparator 610. Comparator 610 may be a low-input offset and low quiescent current (I_{Q}) voltage comparator in one example. Comparator 610 includes a first comparator input 612, a second comparator input 614, and a comparator output 616. Comparator output 616 may provide a signal to digital circuitry or a controller (not shown in FIG. 6) responsive to a condition being met in channel driver 600. FIG. 6 also includes auxiliary output current 618, which may provide auxiliary power to a load in one example.

Channel driver 600 may have a diode connected power FET 104 as a voltage clamp in one example. In this example, switch 160 is activated to place power FET 104 in a diode connected configuration by coupling the gate 108 of power FET 104 to the drain 112 of power FET 104. In the diode connected configuration, charge pump 114 is disconnected from gate 108 of power FET 104. In this configuration, shown in FIG. 6, channel driver 600 is operating in a low-power-mode, where transistor 602 is on and provides output current I_{OUT} 182 to load 140. Transistor 602 may be a p-channel FET (PFET) in this example. In some examples, transistor 602 may be turned on with an I_{Q} of less than 50 microamps. First bias current source 606 and second bias current source 608 may be provide current as small as a few hundreds nanoamps in an example. Therefore, in this configuration, channel driving I_{Q} may be as small as a few microamps per channel.

Comparator 610 has a first comparator input 612 coupled to voltage source VS 122 and a second comparator input 614 coupled to load 140. Comparator 610 is configured to detect any load condition changes by performing a comparison and providing an LPM exit control signal at comparator output 616 based on the comparison. If the voltage V_{OUT} at load 140 drops below the voltage provided by voltage source Vs 122 by a predetermined threshold, comparator 610 provides the LPM exit control signal at comparator output 616. The LPM exit control signal may be provided to digital circuitry or a controller in an example. Responsive to the LPM exit control signal, channel driver 600 exits the LPM. To exit the LPM, a controller causes switch 160 to disconnect power FET 104 from the diode-connected configuration, and causes charge pump 114 to resume providing a voltage to gate 108 of power FET 104. Charge pump 114 provides the voltage to gate 108 to turn on and drive power FET 104 for operation in a normal mode (e.g., a non-low-power-mode). The detection threshold may be determined, in one example, based on the size of transistor 602 and the maximum output current I_{OUT} 182 supported in the LPM. As one example, the voltage threshold of comparator 610 may be a maximum direct current (DC) value of output current I_{OUT} 182 multiplied by the resistance of transistor 602 if transistor 602 is on.

In examples herein, the PMOS power stage 162 improves current sense accuracy for wire break detection in parallel with the sense circuitry of the power FET 104. The existing sense amplifier 132 of the high-side switch is useful for the wire break mode, so no additional amplifier is added to the circuit, which saves area. Multiple thresholds may be enabled for entering/exiting the wire break mode and for detecting a wire break, as described above with respect to FIGS. 2A and 2B. Also, by connecting the power FET 104 in a diode-connected configuration during the wire break mode, the output voltage V_{OUT} drop may be limited during a sudden output load current increase, which may otherwise be unsupported by the smaller PMOS power stage 162.

In other examples, a low-power-mode channel driver is provided. A comparator 610 may place the channel driver in either the LPM or a normal operating mode by providing a signal to a controller or digital circuitry. If output voltage V_{OUT} drops below an acceptable threshold, comparator 610 may provide a signal to exit the LPM and resume operating in a normal mode. The LPM may reduce channel driving I_{Q} to as small as a few microamps per channel in some examples.

In this description, the term "couple" may cover connections, communications or signal paths that enable a functional relationship consistent with this description. For example, if device A provides a signal to control device B to perform an action, then: (a) in a first example, device A is directly connected to device B; or (b) in a second example, device A is coupled to device B through intervening component C if intervening component C does not alter the functional relationship between device A and device B, so device B is controlled by device A via the control signal provided by device A.

A device that is "configured to" perform a task or function may be configured (e.g., programmed and/or hardwired) at a time of manufacturing by a manufacturer to perform the function and/or may be configurable (or reconfigurable) by a user after manufacturing to perform the function and/or other additional or alternative functions. The configuring may be through firmware and/or software programming of the device, through a construction and/or layout of hardware components and interconnections of the device, or a combination thereof.

A circuit or device that is described herein as including certain components may instead be adapted to be coupled to those components to form the described circuitry or device. For example, a structure described as including one or more semiconductor elements (such as transistors), one or more passive elements (such as resistors, capacitors, and/or inductors), and/or one or more sources (such as voltage and/or current sources) may instead include only the semiconductor elements within a single physical device (e.g., a semiconductor die and/or integrated circuit (IC) package) and may be adapted to be coupled to at least some of the passive elements and/or the sources to form the described structure either at a time of manufacture or after a time of manufacture, for example, by an end-user and/or a third-party.

While certain components may be described herein as being of a particular process technology, these components may be exchanged for components of other process technologies. Circuits described herein are reconfigurable to include the replaced components to provide functionality at least partially similar to functionality available prior to the component replacement. Components shown as resistors, unless otherwise stated, are generally representative of any one or more elements coupled in series and/or parallel to provide an amount of impedance represented by the shown resistor. For example, a resistor or capacitor shown and described herein as a single component may instead be multiple resistors or capacitors, respectively, coupled in parallel between the same nodes. For example, a resistor or capacitor shown and described herein as a single component may instead be multiple resistors or capacitors, respectively, coupled in series between the same two nodes as the single resistor or capacitor.

Uses of the phrase "ground" in the foregoing description include a chassis ground, an Earth ground, a floating ground, a virtual ground, a digital ground, a common ground, and/or any other form of ground connection applicable to, or suitable for, the teachings of this description. In this description, unless otherwise stated, "about," "approximately" or "substantially" preceding a parameter means being within +/- 10 percent of that parameter. Modifications are possible in the described examples, and other examples are possible within the scope of the claims.

## Claims

1. A system (100), comprising:
a sense amplifier (132) including a first input (134), a second input (136) and an output (138), wherein the second input (136) is coupled to a load terminal and the output (138) is coupled to a transistor (142);
a first power stage (102) including a first power field effect transistor, FET, (104) and a first sense transistor (106) coupled to the first power FET (104), wherein the first power stage (102) is configured to provide a first current (Iₒᵤₜ) having a first value to the load terminal, wherein the first sense transistor (106) is coupled to the first input (134) of the sense amplifier (132) during a first mode of operation, wherein, during the first mode of operation, the first sense transistor (106) is configured to sense the provided first current (Iₒᵤₜ);
a second power stage (162) including a second power FET (172) and a second sense transistor (174) coupled to the second power FET (172), wherein the second power stage (162) is smaller than the first power stage (102), and wherein the second power stage (162) is configured to provide a second current (Iₒᵤₜ) having a second value to the load terminal, wherein the second sense transistor (174) is coupled to the first input (134) of the sense amplifier (132) during a second mode of operation, the first value being different to the second value;
a first switch (160) coupled to a gate (108) and a drain (112) of the first power FET (104), wherein the first switch (160) is configured to connect the gate (108) to the drain (112) of the first power FET (104); and
a second switch (130) coupled to the first power stage (102) and the second power stage (162), wherein the second switch (130) is configured to connect the first power stage (102) or the second power stage (162) to a sense amplifier (132).

2. The system of claim 1, wherein the second mode of operation is a low power mode of operation.

3. The system of claim 1, further comprising:
a charge pump (114) coupled to the gate (108) of the first power FET (104) and configured to bias the first power FET (104).

4. The system of claim 1, wherein the first switch (160) is configured to disconnect the gate (108) from the drain (112) of the first power FET (108) during the first mode of operation, and the second switch (130) is configured to connect the first power stage (102) to the sense amplifier (132) during the first mode of operation.

5. The system of claim 1, wherein the first switch (160) is configured to connect the gate (108) to the drain (112) of the first power FET (108) during the second mode of operation, and wherein the second switch (130) is configured to connect the second power stage (162) to the sense amplifier (132) during the second mode of operation.

6. The system of claim 5, wherein a charge pump (114) is coupled to the gate (108) of the first power FET (104), and entering the second mode of operation disables the charge pump (114).

7. The system of claim 1, wherein, responsive to a sense current (184) provided to the sense amplifier (132) falling below a threshold, the first switch (160) and the second switch (130) are configured to change states.

8. The system of claim 7, wherein the threshold is a first threshold, the sense current (184) is a first sense current, and responsive to a second sense current falling below a second threshold, a controller (186) is configured to generate a wire break fault.

9. The system of claim 8, wherein the second threshold is lower than the first threshold.

10. A method, comprising:
providing a first current (Iₒᵤₜ) having a first value to a load (140) with a first power stage (102) in a first mode of operation, wherein the first power stage (102) includes a first power field effect transistor, FET, (104) and a first sense transistor (106), the first sense transistor (106) being coupled to a first input (134) of a sense amplifier (132) during the first mode of operation, the sense amplifier (132) including a first input (134), a second input (136) and an output (138), the second input (136) being coupled to the load (140) and the output (138) being coupled to a transistor (142);
sensing, by the first sense transistor (106) during the first mode of operation, the provided first current (Iₒᵤₜ);
switching to a second mode of operation; and
responsive to switching to the second mode of operation:
providing a second current (Iₒᵤₜ) having a second value to the load (140) with a second power stage (162), wherein the second power stage (162) includes a second power FET (172) and a second sense transistor (174), the second sense transistor (174) being coupled to the first input (134) of the sense amplifier (132) during the second mode of operation, the first value being different to the second value;
connecting the first power FET (104) in a diode connected configuration; and
coupling the second sense transistor (174) to the sense amplifier (132).

11. The method of claim 10, wherein switching to the second mode of operation includes switching to the second mode of operation responsive to the first current (Iₒᵤₜ) having a first value crossing a first threshold.

12. The method of claim 10, further comprising the first power FET (104) providing an auxiliary current (188) to the load (140) in the second mode of operation.

13. The system of claim 1, further comprising:
a comparator (190) having a comparator output (196), a first comparator input (192), and a second comparator input (194), wherein:
the first comparator input (192) is coupled to a voltage supply terminal;
the second comparator input (194) is coupled to the load terminal; and
the comparator (190) is configured to provide a signal to exit the second mode of operation based on a comparison between a supply voltage and a voltage at the load terminal.

14. The system of claim 13, wherein exiting the second mode of operation includes:
disconnecting the first power FET (104) from the diode-connected configuration;
coupling a charge pump (114) to the gate (108) of the first power FET (104); and
providing the first current (Iₒᵤₜ) having a first value to the load terminal.

15. The system of claim 13, wherein the comparator (190) is configured to, responsive to the voltage at the load terminal falling below a predetermined threshold, exit the second mode of operation.

## Patentansprüche

1. System (100), das Folgendes umfasst:
einen Leseverstärker (132), der einen ersten Eingang (134), einen zweiten Eingang (136) und einen Ausgang (138) aufweist, wobei der zweite Eingang (136) mit einem Lastanschluss gekoppelt ist und der Ausgang (138) mit einem Transistor (142) gekoppelt ist;
eine erste Leistungsstufe (102), die einen ersten Leistungs-Feldeffekttransistor (FET) (104) und einen ersten Lesetransistor (106), der mit dem ersten Leistungs-FET (104) gekoppelt ist, aufweist, wobei die erste Leistungsstufe (102) dazu ausgebildet ist, einen ersten Strom (Iₒᵤₜ) mit einem ersten Wert an den Lastanschluss bereitzustellen, wobei der erste Lesetransistor (106) während des ersten Betriebsmodus mit dem ersten Eingang (134) des Leseverstärkers (132) gekoppelt ist, wobei der erste Lesetransistor (106) dazu ausgebildet ist, den bereitgestellten ersten Strom (Iₒᵤₜ) zu erfassen;
eine zweite Leistungsstufe (162), die einen zweiten Leistungs-FET (172) und einen zweiten Lesetransistor (174) aufweist, die mit dem zweiten Leistungs-FET (172) gekoppelt sind, wobei die zweite Leistungsstufe (162) kleiner als die erste Leistungsstufe (102) ist, und wobei die zweite Leistungsstufe (162) dazu ausgebildet ist, einen zweiten Strom (Iₒᵤₜ) mit einem zweiten Wert an den Lastanschluss bereitzustellen, wobei der zweite Lesetransistor (174) während eines zweiten Betriebsmodus mit dem ersten Eingang (134) des Leseverstärkers (132) gekoppelt ist, wobei sich der erste Wert von dem zweiten Wert unterscheidet;
einen ersten Schalter (160), der mit einem Gate (108) und einem Drain (112) des ersten Leistungs-FET (104) gekoppelt ist, wobei der erste Schalter (160) dazu ausgebildet ist, das Gate (108) mit dem Drain (112) des ersten Leistungs-FET (104) zu verbinden; und
einen zweiten Schalter (130), der mit der ersten Leistungsstufe (102) und der zweiten Leistungsstufe (162) gekoppelt ist, wobei der zweite Schalter (130) dazu ausgebildet ist, die erste Leistungsstufe (102) oder die zweite Leistungsstufe (162) mit einem Leseverstärker (132) zu verbinden.

2. System nach Anspruch 1, wobei der zweite Betriebsmodus ein Niederleistungs-Betriebsmodus ist.

3. System nach Anspruch 1, das ferner Folgendes umfasst:
eine Ladungspumpe (114), die mit dem Gate (108) des ersten Leistungs-FET (104) gekoppelt ist und dazu ausgebildet ist, den ersten Leistungs-FET (104) vorzuspannen.

4. System nach Anspruch 1, wobei der erste Schalter (160) dazu ausgebildet ist, das Gate (108) von dem Drain (112) des ersten Leistungs-FET (108) während des ersten Betriebsmodus zu trennen, und der zweite Schalter (130) dazu ausgebildet ist, die erste Leistungsstufe (102) während des ersten Betriebsmodus mit dem Leseverstärker (132) zu verbinden.

5. System nach Anspruch 1, wobei der erste Schalter (160) dazu ausgebildet ist, das Gate (108) während des zweiten Betriebsmodus mit dem Drain (112) des ersten Leistungs-FET (108) zu verbinden, und wobei der zweite Schalter (130) dazu ausgebildet ist, die zweite Leistungsstufe (162) während des zweiten Betriebsmodus mit dem Leseverstärker (132) zu verbinden.

6. System nach Anspruch 5, wobei eine Ladungspumpe (114) mit dem Gate (108) des ersten Leistungs-FET (104) gekoppelt ist und das Eintreten in den zweiten Betriebsmodus die Ladungspumpe (114) deaktiviert.

7. System nach Anspruch 1, wobei der erste Schalter (160) und der zweite Schalter (130) als Reaktion darauf, dass ein an den Leseverstärker (132) bereitgestellter Erfassungsstrom (184) unter einen Schwellenwert fällt, dazu ausgebildet sind, ihren Zustand zu ändern.

8. System nach Anspruch 7, wobei der Schwellenwert ein erster Schwellenwert ist, der Erfassungsstrom (184) ein erster Erfassungsstrom ist und als Reaktion darauf, dass ein zweiter Erfassungsstrom unter einen zweiten Schwellenwert fällt, eine Steuerung (186) dazu ausgebildet ist, einen Drahtbruchfehler zu erzeugen.

9. System nach Anspruch 8, wobei der zweite Schwellenwert niedriger als der erste Schwellenwert ist.

10. Verfahren, das Folgendes umfasst:
Bereitstellen eines ersten Stroms (Iₒᵤₜ) mit einem ersten Wert an eine Last (140) mit einer ersten Leistungsstufe (102) in einem ersten Betriebsmodus, wobei die erste Leistungsstufe (102) einen ersten Leistungs-Feldeffekttransistor (FET) (104) und einen ersten Lesetransistor (106) aufweist, wobei der erste Lesetransistor (106) während des ersten Betriebsmodus mit einem ersten Eingang (134) eines Leseverstärkers (132) gekoppelt ist, wobei der Leseverstärker (132) einen ersten Eingang (134), einen zweiten Eingang (136) und einen Ausgang (138) aufweist, wobei der zweite Eingang (136) mit der Last (140) gekoppelt ist und der Ausgang (138) an einen Transistor (142) gekoppelt ist;
Erfassen, durch den ersten Lesetransistor (106) während des ersten Betriebsmodus, des bereitgestellten ersten Stroms (Iₒᵤₜ);
Umschalten auf einen zweiten Betriebsmodus; und
als Reaktion auf das Umschalten auf den zweiten Betriebsmodus:
Bereitstellen eines zweiten Stroms (Iₒᵤₜ) mit einem zweiten Wert an die Last (140) mit einer zweiten Leistungsstufe (162), wobei die zweite Leistungsstufe (162) einen zweiten Leistungs-FET (172) und einen zweiten Lesetransistor (174) aufweist, wobei der zweite Lesetransistor (174) während des zweiten Betriebsmodus mit dem ersten Eingang (134) des Leseverstärkers (132) gekoppelt ist, wobei sich der erste Wert von dem zweiten Wert unterscheidet;
Verbinden des ersten Leistungs-FET (104) in einer diodenverbundenen Konfiguration; und
Koppeln des zweiten Lesetransistors (174) mit dem Leseverstärker (132).

11. Verfahren nach Anspruch 10, wobei das Umschalten auf den zweiten Betriebsmodus das Umschalten auf den zweiten Betriebsmodus als Reaktion darauf beinhaltet, dass der erste Strom (Iₒᵤₜ) einen ersten Wert aufweist, der einen ersten Schwellenwert überschreitet.

12. Verfahren nach Anspruch 10, ferner umfassend den ersten Leistungs-FET (104), der in dem zweiten Betriebsmodus einen Hilfsstrom (188) an die Last (140) bereitstellt.

13. System nach Anspruch 1, das ferner Folgendes umfasst:
einen Komparator (190) mit einem Komparatorausgang (196), einem ersten Komparatoreingang (192) und einem zweiten Komparatoreingang (194), wobei:
der erste Komparatoreingang (192) mit einem Spannungsversorgungsanschluss gekoppelt ist;
der zweite Komparatoreingang (194) mit dem Lastanschluss gekoppelt ist; und
der Komparator (190) dazu ausgebildet ist, ein Signal zum Verlassen des zweiten Betriebsmodus basierend auf einem Vergleich zwischen einer Versorgungsspannung und einer Spannung an dem Lastanschluss bereitzustellen.

14. System nach Anspruch 13, wobei das Verlassen des zweiten Betriebsmodus Folgendes beinhaltet:
Trennen des ersten Leistungs-FET (104) von der diodenverbundenen Konfiguration;
Koppeln einer Ladungspumpe (114) mit dem Gate (108) des ersten Leistungs-FET (104); und
Bereitstellen des ersten Stroms (Iₒᵤₜ) mit einem ersten Wert an den Lastanschluss.

15. System nach Anspruch 13, wobei der Komparator (190) dazu ausgebildet ist, als Reaktion darauf, dass die Spannung an dem Lastanschluss unter einen vorbestimmten Schwellenwert fällt, den zweiten Betriebsmodus zu verlassen.

## Revendications

1. Système (100) comprenant :
un amplificateur de détection (132) comprenant une première entrée (134), une deuxième entrée (136) et une sortie (138), la deuxième entrée (136) étant couplée à une borne de charge et la sortie (138) étant couplée à un transistor (142) ;
un premier étage de puissance (102) comprenant un premier transistor à effet de champ de puissance, FET (104) et un premier transistor de détection (106) couplé au premier FET de puissance (104), le premier étage de puissance (102) étant configuré pour fournir un premier courant (Iₒᵤₜ) ayant une première valeur à la borne de charge, le premier transistor de détection (106) étant couplé à la première entrée (134) de l'amplificateur de détection (132) pendant un premier mode de fonctionnement, où, pendant un premier mode de fonctionnement, le premier transistor de détection (106) est configuré pour détecter le premier courant fourni (Iₒᵤₜ) ;
un deuxième étage de puissance (162) comprenant un deuxième FET de puissance (172) et un deuxième transistor de détection (174) couplé au deuxième FET de puissance (172), où le deuxième étage de puissance (162) est plus petit que le premier étage de puissance (102), et où le deuxième étage de puissance (162) est configuré pour fournir un deuxième courant (Iₒᵤₜ) ayant une deuxième valeur à la borne de charge, où le deuxième transistor de détection (174) est couplé à la première entrée (134) de l'amplificateur de détection (132) pendant un deuxième mode de fonctionnement, la première valeur étant différente de la deuxième valeur ;
un premier commutateur (160) couplé à une grille (108) et à un drain (112) du premier FET de puissance (104), le premier commutateur (160) étant configuré pour connecter la grille (108) au drain (112) du premier FET de puissance (104) ; et
un deuxième commutateur (130) couplé au premier étage de puissance (102) et au deuxième étage de puissance (162), le deuxième commutateur (130) étant configuré pour connecter le premier étage de puissance (102) ou le deuxième étage de puissance (162) à un amplificateur de détection (132).

2. Système selon la revendication 1, dans lequel le deuxième mode de fonctionnement est un mode de fonctionnement à faible puissance.

3. Système selon la revendication 1, comprenant en outre :
une pompe de charge (114) couplée à la grille (108) du premier FET de puissance (104) et configurée pour polariser le premier FET de puissance (104).

4. Système selon la revendication 1, dans lequel le premier commutateur (160) est configuré pour déconnecter la grille (108) du drain (112) du premier FET de puissance (108) pendant le premier mode de fonctionnement, et le deuxième commutateur (130) est configuré pour connecter le premier étage de puissance (102) à l'amplificateur de détection (132) pendant le premier mode de fonctionnement.

5. Système selon la revendication 1, dans lequel le premier commutateur (160) est configuré pour connecter la grille (108) au drain (112) du premier FET de puissance (108) pendant le deuxième mode de fonctionnement, et dans lequel le deuxième commutateur (130) est configuré pour connecter le deuxième étage de puissance (162) à l'amplificateur de détection (132) pendant le deuxième mode de fonctionnement.

6. Système selon la revendication 5, dans lequel une pompe de charge (114) est couplée à la grille (108) du premier FET de puissance (104), et l'entrée dans le deuxième mode de fonctionnement désactive la pompe de charge (114).

7. Système selon la revendication 1, dans lequel, en réponse à un courant de détection (184) fourni à l'amplificateur de détection (132) tombant en dessous d'un seuil, le premier commutateur (160) et le deuxième commutateur (130) sont configurés pour changer d'états.

8. Système selon la revendication 7, dans lequel le seuil est un premier seuil, le courant de détection (184) est un premier courant de détection et, en réponse à un deuxième courant de détection tombant en dessous d'un deuxième seuil, un contrôleur (186) est configuré pour générer un défaut de rupture de fil.

9. Système selon la revendication 8, dans lequel le deuxième seuil est inférieur au premier seuil.

10. Procédé comprenant les étapes suivantes :
fournir un premier courant (Iₒᵤₜ) ayant une première valeur à une charge (140) avec un premier étage de puissance (102) dans un premier mode de fonctionnement, où le premier étage de puissance (102) comprend un premier transistor à effet de champ de puissance, FET (104) et un premier transistor de détection (106), le premier transistor de détection (106) étant couplé à une première entrée (134) d'un amplificateur de détection (132) pendant le premier mode de fonctionnement, l'amplificateur de détection (132) comprenant une première entrée (134), une deuxième entrée (136) et une sortie (138), la deuxième entrée (136) étant couplée à la charge (140) et la sortie (138) étant couplée à un transistor (142) ;
détecter, par le premier transistor de détection (106) durant le premier mode de fonctionnement, le premier courant fourni (I_{OUT}) ;
basculer dans un deuxième mode de fonctionnement ; et
en réponse au passage au deuxième mode de fonctionnement ;
fournir un deuxième courant (Iₒᵤₜ) ayant une deuxième valeur à la charge (140) avec un deuxième étage de puissance (162), le deuxième étage de puissance (162) comprenant un deuxième FET de puissance (172) et un deuxième transistor de détection (174), le deuxième transistor de détection (174) étant couplé à la première entrée (134) de l'amplificateur de détection (132) pendant le deuxième mode de fonctionnement, la première valeur étant différente de la deuxième valeur ;
connecter le premier transistor FET de puissance (104) en configuration diode ; et
coupler le deuxième transistor de détection (174) à l'amplificateur de détection (132).

11. Procédé selon la revendication 10, dans lequel la commutation vers le deuxième mode de fonctionnement comprend la commutation vers le deuxième mode de fonctionnement en réponse au premier courant (Iₒᵤₜ) ayant une première valeur franchissant un premier seuil.

12. Procédé selon la revendication 10, comprenant en outre que le premier transistor FET de puissance (104) fournisse un courant auxiliaire (188) à la charge (140) dans le deuxième mode de fonctionnement.

13. Système selon la revendication 1, comprenant en outre :
un comparateur (190) ayant une sortie de comparateur (196), une première entrée de comparateur (192), et une deuxième entrée de comparateur (194), où :
la première entrée de comparateur (192) est couplée à une borne d'alimentation en tension ;
la deuxième entrée de comparateur (194) est couplée à la borne de charge ; et
le comparateur (190) est configuré pour fournir un signal pour sortir du deuxième mode de fonctionnement sur la base d'une comparaison entre une tension d'alimentation et une tension au niveau de la borne de charge.

14. Système selon la revendication 13, dans lequel la sortie du deuxième mode de fonctionnement comprend les étapes suivantes :
déconnecter le premier transistor FET de puissance (104) de la configuration en diode ;
coupler une pompe de charge (114) à la grille (108) du premier FET de puissance (104) ; et
fournir le premier courant (Iₒᵤₜ) ayant une première valeur à la borne de charge.

15. Système selon la revendication 13, dans lequel le comparateur (190) est configuré, en réponse à la tension à la borne de charge tombant en dessous d'un seuil prédéterminé, pour quitter le deuxième mode de fonctionnement.
